# EUROPÄISCHE PATENTSCHRIFT

(11) **EP 2 875 552 B1**
(45) Veröffentlichungstag und Bekanntmachung des Hinweises auf die Patenterteilung: **09.10.2019**
(21) Anmeldenummer: 13730484.6
(22) Anmeldetag: 12.06.2013
(51) Int. Cl.: H01R 12/62, H01R 12/59, H05K 5/00

(54) **KRAFTFAHRZEUGSTEUERMODUL MIT VERBINDUNGSELEMENT UND FAHRZEUG MIT DERARTIGEM KRAFTFAHRZEUGSTEUERMODUL**
MOTOR VEHICLE CONTROL MODULE HAVING A CONNECTING ELEMENT AND VEHICLE HAVING SUCH A MOTOR VEHICLE CONTROL MODULE
MODULE DE COMMANDE DE VÉHICULE À MOTEUR COMPORTANT UN ÉLÉMENT DE CONNEXION, ET VÉHICULE COMPORTANT UN TEL MODULE DE COMMANDE DE VÉHICULE À MOTEUR

(30) Priorität: 18.07.2012 DE 102012014221
(43) Veröffentlichungstag der Anmeldung: 27.05.2015
(73) Patentinhaber: WABCO GmbH, 30453 Hannover (DE)
(72) Erfinder: BRAMMER, Christian, 29303 Bergen (DE); WUSTRACK, Tobias, 30455 Hannover (DE)
(74) Vertreter: Lauerwald, Jörg
(86) Internationale Anmeldenummer: PCT/EP2013/001735
(87) Internationale Veröffentlichungsnummer: WO 2014/012611

(56) Entgegenhaltungen:
- EP-A1- 0 410 426
- DE-A1- 3 937 190
- DE-A1- 4 321 331
- DE-A1-102005 020 926
- DE-C1- 19 816 904
- US-A- 4 647 133
- US-A1- 2002 186 551
- US-B2- 6 937 462

## Beschreibung

Die Erfindung betrifft ein Kraftfahrzeugsteuermodul nach dem Oberbegriff von Anspruch 1, sowie ein Kraftfahrzeug mit einem derartigen Kraftfahrzeugsteuermodul nach Anspruch 5.

In der Fahrzeugtechnik ist die Verwendung verschiedener Steuermodule zur elektronischen Steuerung von Vorgängen in Kraftfahrzeugen, insbesondere Getriebesteuerung, Steuerung des Antiblockiersystems (ABS) und/oder Steuerung des elektronisch geregelten Bremssystems (EBS), bekannt.

Diese Steuermodule weisen im Allgemeinen eine Vielzahl an elektronischen Komponenten auf, welche in Verbindung mit anderen Komponenten außerhalb des Steuermoduls stehen, wobei die Steuermodule den Umwelteinflüssen und mechanischen, thermischen sowie chemischen Beanspruchungen standhalten müssen.

Die Verbindung zu außerhalb der Steuermodule liegenden Komponenten erfolgt über mindestens eine Steckverbindung, welche am Gehäuse des Steuermoduls angeordnet ist. Die Steckverbindung wird über eine elektrische Verbindung von der Gehäuseinnenseite zur Gehäuseaußenseite des Steuermoduls hergestellt. DE 195 15 622 A1 zeigt ein Steuermodul, bei dem die elektronische Verbindung zwischen einer Schaltungsanordnung und Anschlusskontakten eines Anschlusssteckers mittels speziell ausgebildeter Stanzgitter hergestellt wird.

DE 43 21 331 A1, das als nächstliegender Stand der Technik angesehen wird, EP 0 410 426 A1, US 4 647 133 A, US 200/186551 A1, US 6 937 462 B2 und DE 10 2005 020926 A1 offenbaren Steuergeräte, insbesondere für Kraftfahzeuge, und elektrische Verbindungselemente.

Nachteilig hierbei ist jedoch die aufwendige Herstellung und Verbindung einzelner Stanzgitter, da hierzu mehrere Prozessschritte erforderlich sind. Ferner müssen zwingend geeignete Leiterbahnabstände bei der Verwendung von Stanzgittern eingehalten werden. Eine offene Leiterbahnstruktur birgt zudem die Gefahr von Kurzschlüssen durch metallische Partikel.

Der Erfindung liegt daher die Aufgabe zugrunde, eine günstige und Platz sparende elektrische Verbindung zwischen einem Stecker und einer elektronischen Einheit bereit zu stellen.

Die Erfindung löst diese Aufgabe mit einem Kraftfahrzeugsteuermodul nach Anspruch 1, sowie mit einem Kraftfahrzeug nach Anspruch5.

Die Erfindung löst die Aufgabe durch ein Kraftfahrzeugsteuermodul mit einem Verbindungselement zur Herstellung einer elektrischen Verbindung zwischen einem Stecker und einer Kraftfahrzeugsteuerelektronik, mit einer wenigstens eine Leiterbahn aufweisenden Flexfolie.

An der Flexfolie ist an dem einen Leiterbahnende wenigstens ein Kontaktelement befestigt und an dem gegenüberliegenden Leiterbahnende weist die Flexfolie wenigstens eine Bondfläche auf. Dabei ist das Kontaktelement bzw. sind die Kontaktelemente über die an der Flexfolie angeordneten Leiterbahnen elektrisch leitend mit wenigstens einer Bondfläche verbunden.

Durch die Flexfolie entsteht vorteilhaft eine Zugentlastung zwischen den zum Stecker zugehörigen Kontaktelementen und der elektronischen Einheit, wodurch sich ein besserer Toleranzausgleich innerhalb der Gesamtbaugruppe erzielen lässt. Ferner lässt sich eine derartige elektrische Verbindung vorteilhaft besonders Platz sparend durch Ausnutzung der Bondfläche bereitstellen.

Gemäß der Erfindung weist das Verbindungselement ein speziell ausgebildetes Trägerelement auf, an dem die Kontaktelemente angeordnet sind, um die Kontaktelemente des Steckers zu fixieren. Die Stabilität des Steckers wird somit vorteilhaft erhöht. Das Trägerelement ist bevorzugt aus isolierendem Kunststoff ausgeführt.

In einer weiteren bevorzugten Ausführungsform der Erfindung weist die erfindungsgemäße Flexfolie eine elektrisch isolierende Deckschicht auf, welche derart ausgestaltet ist, um die Leiterbahnen der Flexfolie elektrisch voneinander isoliert anzuordnen und die Oberseite der Leiterbahnen elektrisch zu isolieren. Hieraus ergibt sich der Vorteil, das Verbindungselement besonders Platz sparend anordnen zu können, da sehr geringe Leiterbahnabstände mittels einer derartigen Flexfolie realisiert werden können.

Ferner besteht der Vorteil durch die Verwendung einer isolierenden Deckschicht, das Verbindungselement vor Kurzschlüssen durch mögliche metallische Partikel zu schützen.

Die Erfindung löst die o. g. Aufgabe mit einem Kraftfahrzeugsteuermodul, insbesondere einer Getriebesteuerung, Steuerung des Antiblockiersystems (ABS) und/oder Steuerung des elektronisch geregelten Bremssystems (EBS).

Das erfindungsgemäße Steuermodul weist ein Gehäuse auf, bestehend aus mehreren Gehäuseabschnitten. Dabei sind eine Grundplatte und ein Steckerrahmen entweder jeweils separat ausgebildet und bilden je einen Gehäuseabschnitt oder aber die Grundplatte und der Steckerrahmen sind vereint ausgebildet, insbesondere in einem Stück, und bilden daher zusammen ein Gehäuseabschnitt, welcher z.B. wannenförmig bzw. wannenartig ausgebildet ist. Bei einer derartigen wannenförmigen Ausbildung des Gehäuseabschnitts entstehen ein Bodenbereich, welcher weiterhin mit Grundplatte bezeichnet wird und ein seitlich umlaufender Randbereich, welcher weiterhin als Steckerrahmen bezeichnet wird, wobei der wannenförmige Gehäuseabschnitt ein- oder mehrteilig aufgebaut sein kann.

Der Steckerrahmen bzw. der seitlich umlaufende Bereich des wannenförmigen Gehäuseabschnitts weist mindestens eine Öffnung mit Kragen auf. Handelt es sich bei dem Gehäuse um separate Gehäuseabschnitte aus Steckerrahmen und Grundplatte, so ist der Steckerrahmen vorzugsweise mit der Grundplatte verbunden, insbesondere durch Fügen dichtend verbunden.

Innerhalb des Gehäuses ist auf der Grundplatte bzw. auf dem Bodenbereich des wannenförmigen Gehäuseabschnitts eine Leiterplatte befestigt, auf der eine elektronische Einheit, insbesondere eine Kraftfahrzeugsteuerelektronik, angeordnet ist.

Zur Herstellung einer elektrischen Verbindung zwischen der elektronischen Einheit und einem Stecker am Steckerrahmen des Gehäuses weist das erfindungsgemäße Kraftfahrzeugsteuermodul ein Verbindungselement auf, mit einer wenigstens eine Leiterbahn aufweisenden Flexfolie.

Durch die Leiterbahn bzw. die Leiterbahnen wird eine elektrische Verbindung zwischen mindestens einer Bondfläche auf der einen Seite der Flexfolie und einem oder mehreren Kontaktelementen auf der anderen Seite der Flexfolie hergestellt.

Zum Erzeugen einer Steckerschnittstelle am Gehäuse des Steuermoduls werden ein oder mehrere Kontaktelemente mittels eines Trägerelementes in eine Öffnung des Steckerrahmens derart fixiert, dass das Kontaktelement bzw. die Kontaktelemente mit dem zugehörigen Kragen, welcher um die Öffnung des Steckerrahmens angeordnet ist, eine spezifische Steckerschnittstelle bildet, um eine Verbindung zu außerhalb des Steuermoduls liegenden Komponenten zu ermöglichen.

Ein derartiges erfindungsgemäßes Kraftfahrzeugsteuermodul ermöglicht besonders vorteilhaft einen besseren Toleranzausgleich innerhalb des Steuerungsmoduls, da das erfindungsgemäße Verbindungselement durch die Flexfolie mehr Bewegungsspielraum aufweist als ein herkömmlich verwendetes Stanzgitter.

Ferner besteht durch eine derartige elektrische Verbindung mittels einer Flexfolie eine Zugentlastung, sodass eine mechanische Entkopplung zwischen den zur Steckerschnittstelle gehörenden Kontaktelementen im Steckerrahmen und der Leiterplatte erzielt wird.

Die speziell ausgebildeten Bondflächen an der Flexfolie ermöglichen zudem vorteilhaft eine Platz sparende, bauraumoptimierte Lösung einer elektrischen Verbindung, da diese Bondflächen direkt für die elektrische Kontaktierung zur Leiterplatte bereitgestellt werden.

Gemäß einer weiteren Ausführungsform der Erfindung weist das Kraftfahrzeugsteuermodul einen Deckel auf, welcher derart ausgestaltet ist, um das Gehäuse dichtend, insbesondere öldicht, zu verschließen. Dazu weist der Steckerrahmen bevorzugt eine umlaufende Dichtungsnut zur Aufnahme einer Dichtung auf.

Ferner ist der Steckerrahmen bevorzugt in einem Stück ausgebildet, bspw. durch entsprechende Gusstechnik.

Die Erhöhung der Dichtwirkung des Gehäuses erhöht vorteilhaft die Prozesssicherheit des Kraftfahrzeugsteuermoduls.

Gemäß einer weiteren bevorzugten Ausführungsform der Erfindung ist das Trägerelement dichtend, insbesondere öldicht, mit dem Steckerrahmen verbunden. Dabei ist das Trägerelement je nach angewendeter Verbindungstechnik derart ausgestaltet, um das Kontaktelement oder die Kontaktelemente durch die Öffnung im Steckerrahmen aus dem Gehäuseinnern nach außen zu führen. Die Fixierung des Trägerelementes innerhalb der Öffnung im Steckerrahmen erfolgt bspw. durch Pressen, Kleben und/oder Umspritzen, wobei das Trägerelement bevorzugt aus isolierendem Kunststoff besteht.

Durch eine dichtende Verbindung des Trägerelementes mit dem Steckerrahmen erhöht sich vorteilhaft die Dichtwirkung des Gehäuses und somit die Prozesssicherheit des Kraftfahrzeugsteuermoduls.

Gemäß der Erfindung sind Mittel zur mechanischen Befestigung und/oder stoffschlüssigen Befestigung der Bondfläche oder der Bondflächen auf der Leiterplatte vorgesehen. Dabei erfolgt die Befestigung bspw. mittels Nieten oder Schrauben durch ein oder mehrere dafür vorgesehene Durchbohrungen in dem Befestigungsmittel und/oder mittels einer stoffschlüssigen Verbindung, insbesondere durch Kleben, um mögliche Relativbewegungen der Flexfolie bzw. der Bondfläche zu vermeiden.

Durch eine derartige mechanische Befestigung der Bondfläche bzw. der Bondflächen wird vorteilhaft die Sicherheit der elektrischen Kontaktierung der Bondfläche zur Leiterplatte erhöht.

Gemäß einer weiteren bevorzugten Ausführungsform der Erfindung weist das Kontaktelement des Kraftfahrzeugmoduls eine spezielle Formgebung auf. Bevorzugt weist das Kontaktelement einen Kontaktierungsbereich auf, in dem das Kontaktelement eine geringere Fläche aufweist. Dadurch lässt sich das Kontaktelement vorteilhaft in vorbestimmte Löcher der Flexfolie durchführen, um mit der in der Flexfolie enthaltenen Leiterbahn eine elektrische Verbindung herzustellen.

Ferner weist das Kontaktelement einen Abstandsbereich auf, welcher derart ausgestaltet ist, um einen Mindestabstand des Trägerelementes zur Flexfolie einzuhalten. Der Abstandsbereich ermöglicht vorteilhaft ein Umspritzen des Trägerelementes zur Befestigung in einer dafür vorgesehenen Öffnung des Steckerrahmens. Bevorzugt weist das Kontaktelement innerhalb des Abstandsbereiches ein durchgehendes Loch auf, um die Festigkeit beim Umspritzen zu erhöhen.

Ferner weist das Kontaktelement einen Befestigungsbereich auf, bei dem die gradlinigen Oberflächenkonturen teilweise unterbrochen sind, d.h. das Kontaktelement verfügt in dem Befestigungsbereich über Ausbuchtungen, Einkerbungen und/oder einer geriffelten Oberfläche. Eine derartige Oberflächenkontur erhöht vorteilhaft die Festigkeit eines, insbesondere mittels Gusstechnik, befestigten Trägerelementes.

Schließlich löst die Erfindung die Aufgabe mit einem Kraftfahrzeug, welches ein erfindungsgemäßes Kraftfahrzeugsteuermodul aufweist.

Weitere Ausführungsformen der Erfindung ergeben sich aus den Ansprüchen sowie aus den anhand der Zeichnung näher erläuterten Ausführungsbeispielen. In der Zeichnung zeigen:
- Fig. 1: eine schematische Darstellung eines Verbindungselementes mit dargestellten Lötpunkten,
- Fig.2: zwei schematisch dargestellte Verbindungselemente, wobei ein Verbindungselement mit Trägerelement und ein Verbindungselement ohne Trägerelement dargestellt sind,
- Fig.3: eine schematische Teildarstellung eines Steckerrahmens mit drei Verbindungselementen als Explosionsdarstellung und
- Fig. 4: eine schematische Teildarstellung eines Kraftfahrzeugsteuermoduls ohne Deckel in Draufsicht.

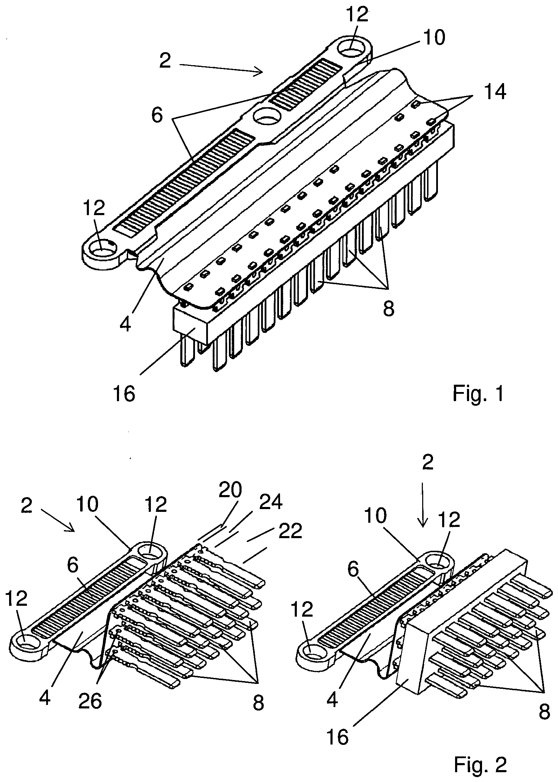

Fig. 1 zeigt eine schematische Darstellung eines erfindungsgemäßen Verbindungselements 2. Dabei ist das erfindungsgemäße Verbindungselement 2 derart ausgestaltet, um eine elektrische Verbindung zwischen einem Stecker und einer (starren) Leiterplatte herzustellen.

Zur Realisierung einer Zugentlastung zwischen dem Stecker und der Leiterplatte weist das Verbindungselement 2 eine Flexfolie 4 auf, welche für die entsprechende Entkopplung zwischen Stecker und Leiterplatte sorgt. Die Verwendung einer derartigen Flexfolie 4 erhöht zudem vorteilhaft die dynamische und mechanische Belastbarkeit der elektrischen Verbindung, insbesondere bzgl. Schüttel- und Vibrationsbelastungen.

Die Flexfolie 4 besteht im Wesentlichen aus einer flexiblen Trägerfolie, welche bevorzugt aus Polyester oder Polyimid gefertigt ist, und weist mindestens eine Leiterbahn auf. Flexfolien werden daher auch als flexible Leiterplatten bezeichnet. Die Leiterbahnen sind aus einem elektrisch leitfähigen Material, insbesondere aus Kupfer bzw. einer Kupferlegierung, und sind einzeln elektrisch voneinander isoliert angeordnet. Ferner weist die Flexfolie 4 eine isolierende Deckschicht auf, wobei Lacke oder Folien zum Einsatz kommen, um die Oberseite der Leiterbahnen elektrisch zu isolieren. Eine derartige Deckschicht verringert vorteilhaft die Störanfälligkeit der Flexfolie 4 bzgl. Kurzschlüsse gegenüber herkömmlichen Stanzgittern, da aufgrund der Deckschicht keine offene Leiterbahnstruktur vorliegt.

Ein Kontaktieren der Flexfolie 4 bzw. der enthaltenen Leiterbahnen mit der Leiterplatte erfolgt bevorzugt mittels Bonden. Unter Bonden wird eine bekannte stoffschlüssige Verbindungstechnik verstanden, bei der zwei Materialien, Komponenten und/oder Anschlusselemente mittels Temperatur und Druck und/oder Ultraschall verbunden werden. Eine vorherrschende Technik ist dabei das Drahtbonden, bei der ein feiner Draht mit den Anschlussflächen stoffschlüssig verbunden wird.

Zum elektrischen Verbinden der Flexfolie 4 mit der Leiterplatte weist die Flexfolie 4 an einem Ende mindestens eine Bondfläche 6 auf. Die Bondfläche 6 dient der Kontaktierung eines Bonddrahtes auf der Flexfolie 4 und ist direkt auf der Flexfolie 4 angeordnet.

Zur Vermeidung von Relativbewegungen ist die Flexfolie 4 im Bereich der Bondflächen 6 mit einem Befestigungsmittel 10 zur mechanischen Befestigung versehen, welches derart ausgestaltet ist, um die Bondfläche mechanisch mit der Leiterplatte zu verbinden. Das Befestigungsmittel 10 ist beispielsweise aus formstabilem Kunststoff ausgeführt und weist wenigstens ein Durchgangsloch 12 auf. Durch dieses Durchgangsloch 12 können einfache Mittel zum Befestigen der Bondfläche 6 auf der Leiterplatte geführt werden, wie beispielsweise Nieten oder Schrauben.

Die den Bondflächen 6 gegenüber liegenden Enden der Leiterbahnen der Flexfolie 4 sind mit einem oder mehreren Kontaktelementen 8 elektrisch verbunden. Zur Herstellung einer elektrisch leitfähigen Verbindung der Leiterbahnenden mit den Kontaktelementen 8 ist die Flexfolie 4 an den Kontaktstellen abschnittsweise gelocht. Bevorzugt ist um die Lochfläche eine lötbare Oberfläche aufgebracht. Die stiftförmigen Kontaktelemente 8 lassen sich auf einfache Weise in die auf der Flexfolie 4 vorgesehenen Lötlöcher hindurchführen und dort elektrisch mit den Leiterbahnen verbinden. Die Verbindung erfolgt dabei bevorzugt mittels bekanntem Lötprozess oder Laserschweißprozess. In Fig. 1 ist die elektrisch leitende Verbindung durch Lötpunkte 14 auf der Flexfolie 4 dargestellt.

Um die Kontaktelemente 8 für den Stecker bereitzustellen, ist ein speziell ausgebildetes Trägerelement 16 vorgesehen. Fig. 2 zeigt zwei Verbindungselemente 2 gemäß den vorstehenden Ausführungen, wobei das eine Verbindungselement 2 ohne Trägerelement 16 dargestellt ist und das andere Verbindungselement 2 mit Trägerelement 16 dargestellt ist. Dabei bezeichnen gleiche Bezugsziffern in Fig. 1 und 2 auch gleiche Elemente.

In dem Ausführungsbeispiel der Erfindung gemäß Fig. 2 weisen die Verbindungselemente 2 jeweils 21 Kontaktelemente 8 auf, die bevorzugt die gleiche Form aufweisen.

Das einzelne Kontaktelement 8 lässt sich bezüglich der Formgebung in verschiedene Bereiche unterteilen. Innerhalb eines Kontaktierungsbereiches 20 weist das Kontaktelement 8 eine besonders geringe Breite auf, um das Kontaktelement 8 in die dafür vorgesehenen Lötlöcher durch die Flexfolie 4 zu stecken. Der Kontaktierungsbereich 20 des Kontaktelementes 8 endet mit einer Verbreiterung des Kontaktelements 8. Dieser stufenförmige Absatz, welcher bevorzugt größer als der Lochdurchmesser des Lötloches ausgebildet ist, dient zum Auflegen der Flexfolie 4. Somit wird die Flexfolie 4 innerhalb des Kontaktierungsbereichs 20 des Kontaktelements 8 gehalten.

Ein speziell ausgebildetes, zwischen den Kontaktelementen 8 angeordnetes Trägerelement 16 befindet sich in einem Befestigungsbereich 22 des Kontaktelements 8. Innerhalb des Befestigungsbereichs 22 verfügen die Kontaktelemente 8 über keine geradlinige Oberflächenkontur. Das heißt, die Kontaktelemente 8 weisen im Befestigungsbereich 22 Ausbuchtungen, Einkerbungen und/oder eine geriffelte Oberfläche auf. Eine derartige Oberflächenkontur sorgt für eine erhöhte Festigkeit bei der Verbindung des Trägerelements 16 mit den Kontaktelementen 8.

Zwischen dem Kontaktierungsbereich 20 und dem Befestigungsbereich 22 befindet sich ein Abstandsbereich 24 an dem Kontaktelement 8. Innerhalb des Abstandsbereichs 24 weisen die Kontaktelemente 8 kleine Löcher 26 auf. Die Löcher 26 sorgen im Falle einer Befestigung der Kontaktelemente 8 in eine extra für eine Steckverbindung vorgesehene Öffnung mittels eines Umgussverfahrens vorteilhaft für eine erhöhte Festigkeit bei der Steckerausführung.

Das Trägerelement 16 ist bspw. als Spritzgussteil aus Isolierstoff gefertigt und fixiert die Kontaktelemente 8, welche in dem Trägerelement 16 eingespritzt und/oder eingepresst sind und beidseitig vom Trägerelement 16 abstehen. Dabei sind die Form und Ausführung des Trägerelementes 16 abhängig von einer zu erzeugenden Steckerschnittstelle für den Anschluss eines entsprechend ausgestalteten Gegensteckers. Das Trägerelement 16 bildet somit eine formstabile Basis für die Kontaktelemente 8.

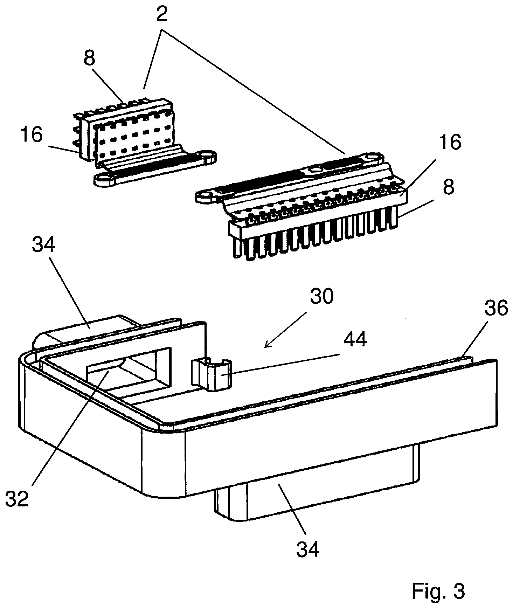

Fig. 3 zeigt eine schematische Teildarstellung eines Steckerrahmens 30 mit zwei Verbindungselementen 2 in einer Explosionsdarstellung.

Zur Realisierung von Steckerschnittstellen, gemäß dem in Fig. 3 dargestelltem Ausführungsbeispiel der Erfindung, weist der Steckerrahmen 30 Öffnungen 32 mit jeweils einem zugehörigen Kragen 34 auf, wobei die Ausgestaltung des Kragens 34 abhängig ist von der zu realisierenden Steckerschnittstelle. Die Kontur des Kragens 34 dient der Führung und der Verriegelung eines zugehörigen Anschlusssteckers.

Der Steckerrahmen 30 ist bevorzugt aus einem Kunststoff in einem Stück gefertigt und weist eine umlaufende Dichtungsnut 36 auf, welche derart ausgestaltet ist, um eine Dichtung in geeigneter Form aufzunehmen. Ferner ist eine derartige Dichtungsnut mit einer Dichtung in geeigneter Form ebenfalls an der Unterseite des Steckerrahmens 30 denkbar.

Die Kontaktelemente 8 jeweils eines Verbindungselementes 2 werden mittels des zugehörigen Trägerelementes 16 in jeweils einer Öffnung 32 des Steckerrahmens 30 fixiert und bilden zusammen mit dem zur Öffnung 32 zugehörigen Kragen 34 eine spezifische Steckerschnittstelle.

Die Befestigung des Trägermoduls 16 in der Öffnung 32 des Steckerrahmens 30 erfolgt bevorzugt mittels eines stoffschlüssigen Fügeverfahrens, insbesondere Pressverfahren, Kleben oder Umspritztechniken. Ein derartiges Fügeverfahren ermöglicht vorteilhaft eine dichtende Verbindung zwischen Trägerelement 16 und Steckerrahmen 30. Dabei ist die Ausgestaltung des bevorzugt aus isolierendem Kunststoff gefertigten Trägerelements 16 abhängig von dem zu verwendenden Fügeverfahren und der zu realisierenden Steckerschnittstelle.

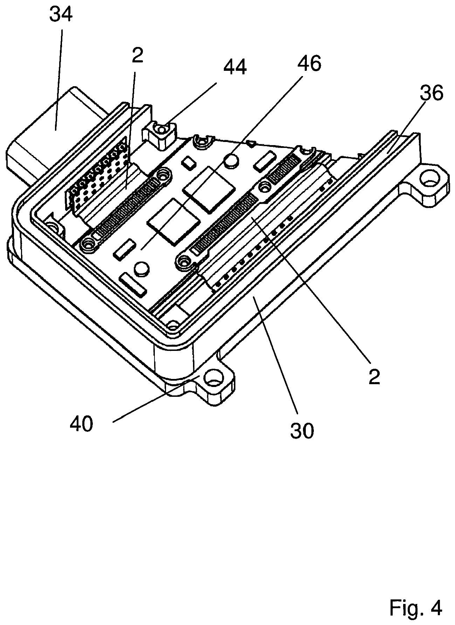

Fig. 4 zeigt eine schematische Teildarstellung eines Kraftfahrzeugsteuermoduls gemäß einem Ausführungsbeispiel der Erfindung.

Das erfindungsgemäße Kraftfahrzeugsteuermoduls weist ein Gehäuse auf, welches sich aus einer Grundplatte 40, dem Steckerrahmen 30 und einem hier nicht dargestellten Deckel zusammensetzt. Bevorzugt ist zwischen dem Deckel und dem Steckerrahmen 30 sowie zwischen der Grundplatte 40 und dem Steckerrahmen 30 jeweils eine Dichtung vorgesehen. Dadurch sind die einzelnen Komponenten dichtend, insbesondere öldicht, miteinander verbunden.

Für eine Befestigung von Grundplatte 40 und Steckerrahmen 30 ist an dem Steckerrahmen 30 mindestens eine Halterung 44 mit einer Öffnung vorgesehen, zur Aufnahme von Befestigungsmitteln, wie beispielsweise Nieten und/oder Schrauben.

Die Grundplatte 40 ist bevorzugt formstabil ausgebildet, insbesondere als eine Aluminium-Platte, und dient als Träger für eine Leiterplatte 46. Auf der Leiteplatte 46 ist eine Vielzahl elektronischer Bauelemente angeordnet, welche eine elektronische Einheit, insbesondere eine Kraftfahrzeugsteuerelektronik, bilden.

Die Erfindung ist jedoch nicht auf eine ebene, flache Ausgestaltung der Grundplatte 40 beschränkt. Vielmehr kann die Grundplatte 40 an beliebige Gehäuseformen sowie Leiterplattenformen angepasst sein.

Alternativ sind die Grundplatte 40 und der Steckerrahmen 30 gemeinsam zu einem wannenförmigen bzw. wannenartigen Gehäuseabschnitt zusammengefasst und insbesondere in einem Stück ausgebildet. Bei einer derartigen wannenförmigen Ausgestaltung des Gehäuses wird der Bodenbereich als Grundplatte und der seitlich umlaufende Bereich als Steckerrahmen bezeichnet, so dass vorstehend ausgeführte Beschreibungen bzgl. der Grundplatte und des Steckerrahmens ebenso für eine wannenförmige Ausgestaltung des Gehäuses gelten.

Zur Herstellung einer elektrischen Verbindung zwischen einem Stecker und der elektronischen Einheit, weist das Kraftfahrzeugsteuermodul mindestens ein vorstehend näher erläutertes Verbindungselement 2 auf.

Der Stecker entspricht hier einer spezifischen Steckerschnittstelle und setzt sich aus den Kontaktelementen 8 eines Verbindungselementes 2, der Öffnung 32 im Steckerrahmen 30 mit dem zugehörigen Kragen 34 zusammen.

Sämtliche in der vorstehenden Beschreibung sowie in den Ansprüchen genannten Merkmale sind erfindungsgemäß sowohl einzeln als auch in beliebiger Kombination miteinander einsetzbar. Die Offenbarung der Erfindung ist daher nicht auf die beschriebenen bzw. beanspruchten Merkmalskombinationen beschränkt. Vielmehr sind alle Kombinationen von Einzelmerkmalen als offenbart zu betrachten.

## Patentansprüche

1. Kraftfahrzeugsteuermodul mit einem Gehäuse,
wobei das Gehäuse mehrere Gehäuseabschnitte ausweist, wobei eine Grundplatte (40) und ein Steckerrahmen (30) jeweils separat ausgebildet sind und daher je einen Gehäuseabschnitt bilden oder die Grundplatte (40) und der Steckerrahmen (30) vereint ausgebildet sind und daher zusammen einen Gehäuseabschnitt bilden, wobei die Grundplatte (40) eine darauf angeordnete Leiterplatte (46) aufweist, welche derart ausgestaltet ist, um eine elektronische Einheit, insbesondere eine Kraftfahrzeugsteuerelektronik, zu bilden und wobei der Steckerrahmen (30) wenigstens eine Öffnung (32) mit Kragen (34) aufweist, wobei das Gehäuse wenigstens eine elektrische Verbindung mittels eines Verbindungselementes (2) zur Herstellung einer elektrischen Verbindung zwischen einem Stecker und der elektronischen Einheit, insbesondere eine Kraftfahrzeugsteuerelektronik aufweist, wobei das Verbindungselement (2) eine Flexfolie (4) aufweist, welche eine oder mehrere Leiterbahnen aufweist, wobei das Verbindungselement (2) eine oder mehrere an der Flexfolie (4) angeordnete Bondflächen (6) aufweist, welche derart ausgestaltet sind, um wenigstens eine elektrische Verbindung der Flexfolie (4) mit der elektronischen Einheit herzustellen und wobei das Verbindungselement (2) ein oder mehrere Kontaktelemente (8) aufweist, wobei das Kontaktelement (8) oder die Kontaktelemente (8) über wenigstens eine Leiterbahn mit der Bondfläche (6) elektrisch verbunden sind, wobei ein oder mehrere Kontaktelemente (8) mittels eines Trägerelementes (16) in eine Öffnung (32) des Steckerrahmens (30) fixiert sind, **dadurch gekennzeichnet, dass** mittels der wenigstens einen Bondfläche (6) durch Drahtbonden eine elektrische Verbindung zwischen der Leiterbahn oder den Leiterbahnen der Flexfolie (4) und der auf der Leiterplatte (46) befindlichen elektronischen Einheit hergestellt ist, wobei die Flexfolie (4) ein Befestigungsmittel (10) aufweist, mittels dem eine mechanische Befestigung und/oder stoffschlüssige Befestigung, insbesondere Kleben, der Bondfläche (6) oder der Bondflächen (6) auf der Leiterplatte (46) hergestellt ist.

2. Kraftfahrzeugsteuermodul nach Anspruch 1,
**dadurch gekennzeichnet, dass**
das Gehäuse einen Deckel aufweist und bevorzugt gedichtet ausgeführt ist und die Gehäuseabschnitte vorzugsweise in einem Stück ausgebildet sind.

3. Kraftfahrzeugsteuermodul nach einem der Ansprüche 1 bis 2,
**dadurch gekennzeichnet, dass**
das Trägerelement (16) dichtend, insbesondere öldicht, mit dem Steckerrahmen (30) verbunden ist und
das wenigstens eine Kontaktelement (8) nach außen aus dem Gehäuse gerichtet ist.

4. Kraftfahrzeugsteuermodul nach einem der Ansprüche 1 bis 3, **gekennzeichnet durch**
eine spezielle Formgebung der Kontaktelemente (8) des Verbindungselementes (2), umfassend:
einen Kontaktierungsbereich (20), in dem das Kontaktelement (8) eine geringere Fläche aufweist und/oder
einen Abstandsbereich (24), welcher derart ausgestaltet ist, um einen Mindestabstand des Trägerelementes (16) zur Flexfolie (4) einzuhalten und/oder einen Befestigungsbereich (22), welcher derart ausgestaltet ist, um durch Abschaffung der gradlinigen Oberflächenkontur des Kontaktelementes (8) eine erhöhte Festigkeit des Trägerelementes (16) an dem Kontaktelement (8) zu erzielen.

5. Kraftfahrzeug mit einem Kraftfahrzeugsteuermodul nach einem der Ansprüche 1 bis 4.

## Claims

1. Motor vehicle control module comprising a housing, wherein the housing has a plurality of housing sections, wherein a base plate (40) and a plug frame (30) are each designed separately and therefore each form a housing section, or the base plate (40) and the plug frame (30) are designed in a combined manner and therefore form a housing section together, wherein the base plate (40) has a printed circuit board (46) arranged on it, which printed circuit board is configured in such a way as to form an electronic unit, in particular a motor vehicle control electronics system, and wherein the plug frame (30) has at least one opening (32) with collars (34), wherein the housing has at least one electrical connection by means of a connecting element (2) for establishing an electrical connection between a plug and the electronic unit, in particular a motor vehicle control electronics system, wherein the connecting element (2) has a flexible film (4) which has one or more conductor tracks, wherein the connecting element (2) has one or more bonding areas (6) which are arranged on the flexible film (4) and are configured in such a way as to establish at least one electrical connection between the flexible film (4) and the electronic unit, and wherein the connecting element (2) has one or more contact elements (8), wherein the contact element (8) or the contact elements (8) are electrically connected to the bonding area (6) via at least one conductor track, wherein one or more contact elements (8) are fixed into an opening (32) of the plug frame (30) by means of a carrier element (16), **characterized in that** an electrical connection between the conductor track or the conductor tracks of the flexible film (4) and the electronic unit which is located on the printed circuit board (46) is established by means of the at least one bonding area (6) by wire bonding, wherein the flexible film (4) has a fastening means (10) by means of which mechanical fastening and/or cohesive fastening, in particular adhesive bonding, of the bonding area (6) or the bonding areas (6) on the printed circuit board (46) is established.

2. Motor vehicle control module according to Claim 1,
**characterized in that**
the housing has a cover and is preferably embodied in a sealed manner, and the housing sections are preferably designed in one piece.

3. Motor vehicle control module according to either of Claims 1 and 2,
**characterized in that**
the carrier element (16) is connected to the plug frame (30) in a sealing manner, in particular in an oil-tight manner, and
the at least one contact element (8) is directed outwards out of the housing.

4. Motor vehicle control module according to one of Claims 1 to 3,
**characterized by**
special shaping of the contact elements (8) of the connecting element (2), comprising:
a contact-making region (20) in which the contact element (8) has a smaller area and/or
a distance region (24) which is configured in such a way as to maintain a minimum distance of the carrier element (16) in relation to the flexible film (4), and/or
a fastening region (22) which is configured in such a way as to achieve increased fixedness of the carrier element (16) on the contact element (8) by removing the rectilinear surface contour of the contact element (8).

5. Motor vehicle comprising a motor vehicle control module according to one of Claims 1 to 4.

## Revendications

1. Module de commande de véhicule à moteur avec un boîtier,
dans lequel le boîtier présente plusieurs parties de boîtier, dans lequel une plaque de base (40) et un cadre de connecteur (30) sont chacun réalisés séparément et forment dès lors chacun une partie de boîtier ou la plaque de base (40) et le cadre de connecteur (30) sont réalisés sous forme unifiée et forment dès lors ensemble une partie de boîtier, dans lequel la plaque de base (40) présente une plaquette de circuits imprimés (46) disposée sur elle, qui est configurée de façon à former une unité électronique, en particulier une électronique de commande de véhicule à moteur, et dans lequel le cadre de connecteur (30) présente au moins une ouverture (32) avec collet (34), dans lequel le boîtier présente au moins une connexion électrique au moyen d'un élément de connexion (2) pour réaliser une connexion électrique entre un connecteur et l'unité électronique, en particulier une électronique de commande de véhicule à moteur, dans lequel l'élément de connexion (2) est une feuille flexible (4), qui présente une ou plusieurs voie(s) conductrice(s), dans lequel l'élément de connexion (2) présente une ou plusieurs plage(s) de contact (6), qui est/sont configurée (s) de façon à établir au moins une connexion électrique de la feuille flexible (4) avec l'unité électronique et dans lequel l'élément de connexion (2) présente un ou plusieurs élément(s) de contact (8), dans lequel l'élément de contact (8) ou les éléments de contact (8) est/sont électriquement connecté (s) à la plage de contact (6) par au moins une voie conductrice, dans lequel un ou plusieurs élément(s) de contact (8) est/sont fixé(s) dans une ouverture (32) du cadre de connecteur (30) au moyen d'un élément de support (16), **caractérisé en ce qu'**une connexion électrique entre la voie conductrice ou les voies conductrices de la feuille flexible (4) et l'unité électronique se trouvant sur la plaquette de circuits imprimés (46) est réalisée au moyen de ladite au moins une plage de contact (6) par une liaison par fil, dans lequel la feuille flexible (4) présente un moyen de fixation (10), au moyen duquel une fixation mécanique et/ou une fixation matérielle, en particulier un collage, de la plage de contact (6) ou des plages de contact (6) sur la plaquette de circuits imprimés (46) est réalisée.

2. Module de commande de véhicule à moteur selon la revendication 1, **caractérisé en ce que** le boîtier présente un couvercle et est de préférence étanche et les parties de boîtier sont de préférence formées en une seule pièce.

3. Module de commande de véhicule à moteur selon une des revendications 1 à 2, **caractérisé en ce que** l'élément de support (16) est assemblé au cadre de connecteur (30) de façon étanche, en particulier de façon étanche à l'huile, et ledit au moins un élément de contact (8) est orienté vers l'extérieur hors du boîtier.

4. Module de commande de véhicule à moteur selon l'une quelconque des revendications 1 à 3, **caractérisé par**
une forme spéciale des éléments de contact (8) de l'élément de connexion (2), comprenant:
une zone de contact (20), dans laquelle l'élément de contact (8) présente une plus petite surface et/ou
une zone d'écartement (24), qui est configurée de façon à respecter une distance minimale de l'élément de support (16) à la feuille flexible (4) et/ou
une zone de fixation (22), qui est configurée de façon à obtenir, par suppression du contour superficiel rectiligne de l'élément de contact (8), une résistance accrue de l'élément de support (16) à l'élément de contact (8).

5. Véhicule à moteur doté d'un module de commande de véhicule à moteur selon l'une quelconque des revendications 1 à 4.
